# EUROPÄISCHE PATENTSCHRIFT

(11) **EP 0 612 150 B1**
(45) Veröffentlichungstag und Bekanntmachung des Hinweises auf die Patenterteilung: **08.07.1998**
(21) Anmeldenummer: 94102177.6
(22) Anmeldetag: 12.02.1994
(51) Int. Cl.: H03J 1/00, H04N 5/445

(54) **Gerät der Unterhaltungselektronik mit einer Bedieneinheit zur Anwahl von Programmplatznummern**
Entertainment electronics apparatus with a control unit for choosing program location numbers
Dispositif de divertissement électronique avec unité de commande pour le choix des numéros de l'emplacement des programmes

(30) Priorität: 13.02.1993 DE 4304365
(43) Veröffentlichungstag der Anmeldung: 24.08.1994
(73) Patentinhaber: GRUNDIG Aktiengesellschaft, 90762 Fürth (DE)
(72) Erfinder: Rosenberger, Winfried, D-90748 Fürth (DE)

(56) Entgegenhaltungen:
- US-A- 5 075 766
- OPERATOR'S MANUAL OF THE VIDEO CASSETTE RECORDER AKAI VS-4EG/EO SEITEN 3,17,27,29
- PATENT ABSTRACTS OF JAPAN vol. 7, no. 154 (E-185) 6. Juli 1983 & JP-A-58 062 921 (NIPPON DENKI KK) 14. April 1983
- ELECTRONIC SOUND + RTE, Nr.4, 1983, AARAU CH Seiten 36 - 38 HANS-JOACHIM HAASE: 'Mit dem Videorecorder per du. Test: Videorecorder VS-2 EO von Akai'

## Beschreibung

Die Erfindung betrifft ein Gerät der Unterhaltungselektronik mit einem Tuner, welcher auf die den einzelnen Programmplatznummern zugeordneten Empfangsfrequenzen abstimmbar ist, und einer Bedieneinheit zur Anwahl von Programmplatznummern mittels zweier Tasten, von denen eine zur Anwahl von Programmplätzen mit kleinerer Programmplatznummer und die andere zur Anwahl von Programmplätzen mit größerer Programmplatznummer vorgesehen ist.

Geräte der Unterhaltungselektronik werden in Bezug auf die Anzahl ihrer Funktionen und damit die Komplexität ihrer Bedieneinheiten immer umfangreicher. Dies hat zur Folge, daß eine immer größere Anzahl von Tasten auf den Bedieneinheiten notwendig ist, um alle Funktionen des jeweiligen Gerätes auslösen zu können. Der Benutzer ist von der Vielzahl der Tasten oft überfordert.

Weiterhin ist es aus Gründen der Handlichkeit und des Fertigungsaufwandes wünschenswert, möglichst kleine Bedieneinheiten, insbesondere Fernbedienungsgeber, zu haben.

Aus der DE-A1-39 06 585 sind Fernbedienkonzepte für Geräte der Unterhaltungselektronik bekannt, bei welchen dem Benutzer auf einem Bildschirm eine Menüseite angeboten wird. In dieser Menüseite wird mittels einfacher Steuermittel wie einer Kugel, einem Toggel-Schalter, einem Joystick, einer Tasten- und Walzen-Kombination oder auch mit vier Tastschaltern eine Befehlsauswahl vorgenommen.

Weiterhin ist es bekannt, eine Programmumschaltung mittels sog. Up- und Down-Tasten durchzuführen. Beispielsweise ist zur Umschaltung vom Programmplatz 1 zum Programmplatz 10 die Up-Taste neunmal nacheinander zu betätigen. Nach jeder dieser Tastenbetätigungen erfolgt eine Neuabstimmung des Tuners auf die der jeweils angewählten Programmplatznummer zugeordneten Empfangsfrequenz. Diese Art und Weise der Programmplatzumschaltung ist jedoch umständlich und zeitaufwendig, da für die nach jeder Tastenbetätigung erforderliche Neuabstimmung des Tuners ein Zeitaufwand von ca. 0,5 Sekunden notwendig ist. Diese Nachteile werden noch dadurch vergrößert, daß das Programmangebot aufgrund der Möglichkeiten einer Rundfunkprogrammübertragung über Kabel und über Satellit ständig weiter ansteigt.

Aus der Zeitschrift Funk-Technik 39 (1984), Heft 6, S. 238-240, und Heft 7, S. 296-297, ist ein Fernsehempfänger bekannt, bei welchem mittels zweier Tasten eine sequentielle Programmfortschaltung in Richtung höherer bzw. niedrigerer Programmplatznummern möglich ist. Weiterhin wird beim bekannten Fernsehempfänger bei Dauerdruck einer der beiden Tasten eine Autorepeat-Funktion durchgeführt, wobei alle 150 ms zum nächsten Programm weitergeschaltet wird. Dabei tritt jedoch während der Autorepeat-Funktion ein störendes Flimmern auf dem Bildschirm des Fernsehempfängers auf.

Die Aufgabe der Erfindung besteht darin, ein Gerät der Unterhaltungselektronik mit den im Oberbegriff des Anspruchs 1 angegebenen Merkmalen bzw. einen Fernsehempfänger mit den im Oberbegriff des Anspruchs 5 angegebenen Merkmalen derart weiterzubilden, daß die vorstehend beschriebenen Nachteile verringert sind.

Diese Aufgabe wird bei einem Gerät der Unterhaltungselektronik mit den im Oberbegriff des Anspruchs 1 angegebenen Merkmalen durch die im kennzeichnenden Teil des Anspruchs 1 angegebenen Merkmale und bei einem Fernsehempfänger mit den im Oberbegriff des Anspruchs 5 angegebenen Merkmalen durch die im kennzeichnenden Teil des Anspruchs 5 angegebenen Merkmale gelöst. Vorteilhafte Weiterbildungen ergeben sich aus den abhängigen Ansprüchen.

Die Vorteile der Erfindung bestehen insbesondere darin, daß die Bedieneinheit des Gerätes aufgrund des Fehlens von Zifferntasten klein ausgeführt sein kann und daß die Programmschaltung, insbesondere bei weit auseinanderliegenden Programmplatznummern, beschleunigt durchgeführt werden kann. Da die Abstimmung des Tuners auf die gewünschte Empfangsfrequenz erst nach Beendigung des Umschaltvorgangs erfolgt, ist weiterhin kein ständiges Wechseln des Bildinhaltes am Bildschirm sichtbar. Durch die rollierende Anzeige der Programmplatznummer bzw. durch die optische Signalisierung in den in Tabellenform dargestellten Senderkurzbezeichnungen kann der Benutzer den Umschaltvorgang gut kontrollieren und zeitrichtig beenden.

Bei der besonderen Ausgestaltung gemäß Anspruch 2 und 4 werden die bei vielen Bedienkonzepten ohnehin vorhandenen Cursorsteuertasten zur Programmumschaltung verwendet. Weiterhin erfolgt die rollierende Anzeige der Programmplatznummer besonders übersichtlich auf dem Bildschirm des Fernsehempfängers oder auf einer an der Bedienfront des Fernsehempfängers angeordneten Anzeige.

Gemäß der im Anspruch 3 angegebenen Weiterbildung der Erfindung wird der Benutzer durch eine zusätzliche alphanumerische Anzeige auf den laufenden Programmumschaltvorgang aufmerksam gemacht.

In den Ansprüchen 6-8 ist aufgezeigt, welche Bildinhalte während des Programmumschaltvorganges am Bildschirm vorzugsweise dargestellt werden.

Nach dem Anspruch 9 sind die beiden Tasten zur Programmumschaltung in Form eines Wippschalters realisiert.

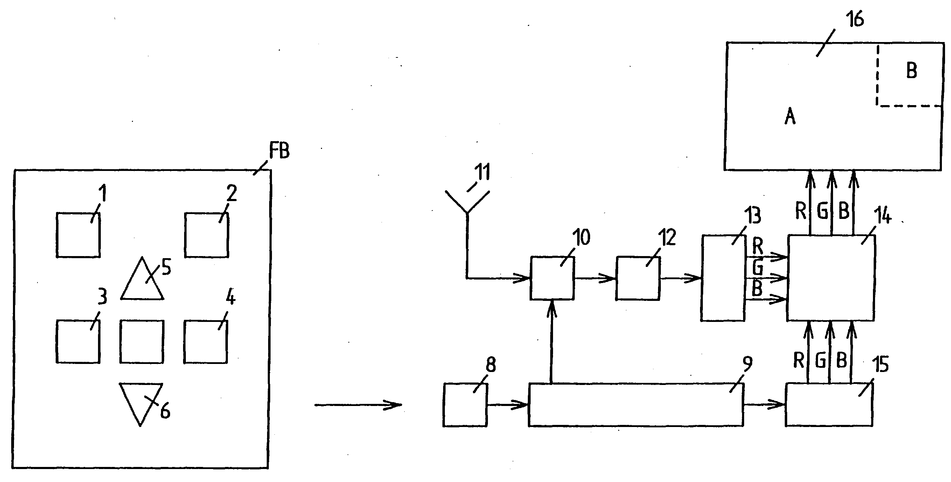

Weitere Eigenschaften der Erfindung ergeben sich aus der Erläuterung eines Ausführungsbeispiels anhand der Figur.

Diese zeigt die zum Verständnis der Erfindung notwendigen Bauteile eines Fernsehempfängers. Dies sind:
- Ein Fernbedienungsgeber FB mit einer Informationstaste 1, einer Ein-/Ausschalttaste 2, einer Taste 3 zur Verringerung der Lautstärke, einer Taste 4 zu Erhöhung der Lautstärke, einer Taste 5 zur Anwahl von Programmplätzen mit größerer Programmplatznummer, einer Taste 6 zur Anwahl von Programmplätzen mit kleinerer Programmplatznummer und einer Bestätigungstaste 7,
- ein Fernbedienempfänger 8,
- ein Mikrocomputer 9,
- ein an eine Antenne 11 oder eine Kabelübertragungsstrecke angeschlossener Tuner 10,
- ein Zwischenfrequenzbaustein 12,
- eine Videosignalverarbeitungsschaltung 13,
- eine Eintastschaltung 14,
- ein DOS-Baustein 15 (**d**isplay **o**n **s**creen) und
- ein Bildschirm 16.

Zur Umschaltung von der Programmplatznummer 1 zur Programmplatznummer 40 wird die Taste 5 des Fernbedienungsgebers FB gedrückt und im Sinne einer Dauerbetätigung gedrückt gehalten. Diese Information wird dem Mikrocomputer 9 über den Fernbedienempfänger 8 übermittelt. Daraufhin steuert der Mikrocomputer 9 den DOS-Baustein 15 derart an, daß das schnelle Durchlaufen in Richtung größerer Programmplatznummern rollierend in alphanumerischer Form auf dem Bildschirm 16 dargestellt wird. Diese Darstellung erfolgt in der rechten oberen Ecke B des Bildschirms, während im Teil A des Bildschirms 16 weiterhin ein Bild des vor Beginn des Programmumschaltvorganges eingestellten Fernsehkanals angezeigt wird.

Bei Erreichen der Programmplatznummer 40 wird das Drücken der Taste 5 beendet. Diese Information wird wiederum dem Mikrocomputer 9 über den Fernbedienempfänger 8 übermittelt. Daraufhin leitet der Mikrocomputer 9 die Abstimmung des Tuners 10 auf die dem Programmplatz 40 entsprechende Empfangsfrequenz ein, so daß erst nach Beendigung des Programmumschaltvorganges ein Wechsel des am Bildschirm gezeigten Programms erfolgt.

Zu der beschriebenen Programmumschaltung werden vorzugsweise die bei vielen Fernbedienkonzepten ohnehin vorhandenen Cursorsteuertasten verwendet, so daß zusätzliche Tasten auf dem Fernbedienungsgeber nicht notwendig sind.

Bei einer zweiten Ausführungsform der Erfindung wird während des Umschaltvorganges, d.h. während der Dauerbetätigung einer der Tasten 5 oder 6, der Bildschirm 16 dunkelgesteuert, so daß der Kontrast zwischen der rollierenden Anzeige der durchlaufenden Programmplatznummer und dem Bildschirmhintergrund vergrößert ist.

Bei einer dritten Ausführungsform der Erfindung wird während des Umschaltvorganges im Bereich A des Bildschirms 16 ein Standbild aus einem nicht gezeichneten Bildspeicher angezeigt, wie er heute in vielen Fernsehempfängern bereits enthalten ist.

Um den Benutzer den laufenden Programmumschaltvorgang noch deutlicher zu signalisieren, kann zusätzlich zu der rollierenden Anzeige der Programmplatznummer eine weitere alphanumerische Anzeige erfolgen, beispielsweise die blinkende Anzeige des Schriftzuges "PROGRAMMWECHSEL".

Die praktische Realisierung der Tasten 5 und 6 erfolgt vorzugsweise entweder in Form zweier separater Tasten oder in Form eines Wippschalters, bei dem die beiden Tasten durch einen Steg miteinander verbunden sind.

Bei einer weiteren Ausgestaltung der Erfindung erfolgt die rollierende Anzeige der Programmplatznummer nicht am Bildschirm des Fernsehempfängers, sondern auf einem an der Bedienfront des Fernsehempfängers angeordneten Anzeige, beispielsweise einer LED-Anzeige oder einer VFD-Anzeige.

Vorstehend wurde die Erfindung am Beispiel eines Fernsehempfängers beschrieben. Selbstverständlich ist die Erfindung auch bei anderen Geräten der Unterhaltungselektronik wie beispielsweise Videorecordern, Satelliten-Empfängern, Hörrundfunkempfängern, usw. verwendbar.

Bei einer alternativen Ausführungsform der Erfindung werden bei einem Fernsehempfänger während des schnellen Durchlaufens in Richtung kleinerer oder größerer Programmplatznummern auf dem Bildschirm 16 den Programmplatznummern zugeordnete Senderkurzbezeichnungen in Tabellenform dargestellt, beispielsweise ARD, ZDF, RTL, usw.. Diese Senderkurzbezeichnungen werden bei der ersten Inbetriebnahme des Fernsehempfängers im Rahmen der Senderprogrammierung in einem nicht gezeichneten nichtflüchtigen Speicher programmplatzbezogen abgelegt. In der genannten Tabelle erfolgt eine optische Signalisierung des schnellen Durchlaufens beispielsweise dadurch, daß sich ein Cursor von einer Senderkurzbezeichnung zur nächsten bewegt, usw., oder daß die jeweils gültige Senderkurzbezeichnung in der Tabelle in einer veränderten Farbe dargestellt wird.

## Patentansprüche

1. Gerät der Unterhaltungselektronik mit einem Tuner, welcher auf die den einzelnen Programmplatznummern zugeordneten Empfangsfrequenzen abstimmbar ist, und einer Bedieneinheit zur Anwahl der Progammplatznummern mittels zweier Tasten, von denen eine zur Anwahl von Programmplätzen mit kleinerer Programmplatznummer und die andere zur Anwahl von Programmplätzen mit größerer Programmplatznummer vorgesehen ist, wobei die Bedieneinheit in einer Betriebsart betreibbar ist, in der ein schnelles Durchlaufen in Richtung kleinerer oder größerer Programmplatznummern erfolgt und das schnelle Durchlaufen während einer Dauerbetätigung einer der beiden Tasten erfolgt,
**dadurch gekennzeichnet**, daß auf einem Display (16) eine rollierende, alphanumerische Anzeige der Programmplatznummer erfolgt, und daß die Abstimmung des Tuners (10) auf eine neue Empfangsfrequenz erst nach Beendigung der genannten Dauerbetätigung einer der beiden Tasten (5, 6) erfolgt.

2. Gerät nach Anspruch 1,
**dadurch gekennzeichnet**, daß
- es ein Fernsehempfänger ist,
- die genannten Tasten (5, 6) auf einem Fernbedienungsgeber (FB) angeordnete Cursorsteuertasten sind, und
- die rollierende Anzeige der Programmplatznummer auf dem Bildschirm (16) des Fernsehempfängers erfolgt.

3. Gerät nach Anspruch 2,
**dadurch gekennzeichnet**, daß der Programmwechselvorgang auf dem Bildschirm (16) zusätzlich zur rollierenden Anzeige der Programmplatznummer alphanumerisch signalisiert wird.

4. Gerät nach Anspruch 1
**dadurch gekennzeichnet**, daß
- es ein Fernsehempfänger ist,
- die genannten Tasten (5, 6) auf einem Fernbedienungsgeber (FB) angeordnete Cursorsteuertasten sind, und
- die rollierende Anzeige der Programmplatznummer auf einer an der Bedienfront des Fernsehempfängers angeordneten Anzeige erfolgt.

5. Fernsehempfänger mit einem Tuner, welcher auf die den einzelnen Programmplatznummern zugeordneten Empfangsfrequenzen abstimmbar ist, und einer Bedieneinheit zur Anwahl der Programmplatznummern mittels zweier Tasten, von denen eine zur Anwahl von Programmplätzen mit kleinerer Programmplatznummer und die andere zur Anwahl von Programmplätzen mit größerer Programmplatznummer vorgesehen ist, wobei die Bedieneinheit in einer Betriebsart betreibbar ist, in der ein schnelles Durchlaufen in Richtung kleinerer oder größerer Programmplatznummern erfolgt und das schnelle Durchlaufen während einer Dauerbetätigung einer der beiden Tasten erfolgt,
**dadurch gekennzeichnet,** daß während des schnellen Durchlaufens in Richtung kleinerer oder größerer Programmplatznummern auf dem Bildschirm (16) des Fernsehempfängers den Programmplatznummern zugeordnete Senderkurzbezeichnungen in Tabellenform dargestellt werden, wobei das schnelle Durchlaufen in der Tabelle optisch signalisiert wird, und daß die Abstimmung des Tuners (10) auf eine neue Empfangsfrequenz erst nach Beendigung der genannten Dauerbetätigung einer der beiden Tasten (5, 6) erfolgt.

6. Gerät nach einem oder mehreren der vorhergehenden Ansprüche,
**dadurch gekennzeichnet,** daß während der genannten Dauerbetätigung einer der beiden Tasten (5, 6) die Abstimmung des Tuners (10) auf die vor Beginn der Dauerbetätigung eingestellte Empfangsfrequenz beibehalten wird.

7. Gerät nach einem oder mehreren der vorhergehenden Ansprüche,
**dadurch gekennzeichnet**, daß während der genannten Dauerbetätigung einer der beiden Tasten (5, 6) der Bildschirm (16) dunkelgesteuert wird.

8. Gerät nach einem oder mehreren der Ansprüche 1-6,
**dadurch gekennzeichnet**, daß während der genannten Dauerbetätigung einer der beiden Tasten (5, 6) am Bildschirm (16) ein Bild aus einem Bildspeicher dargestellt wird.

9. Gerät nach einem oder mehreren der vorhergehenden Ansprüche,
**dadurch gekennzeichnet**, daß die beiden Tasten die Enden eines Wippschalters sind.

## Claims

1. Entertainment-electronics apparatus having a tuner which is tunable to the reception frequencies assigned to the individual programme location numbers, and an operating unit for choosing the programme location numbers by means of two keys, one of which is provided for choosing programme locations having lower programme location number and the other for choosing programme locations having higher programme location number, the operating unit being capable of operation in an operating mode in which a rapid scanning takes place in the direction of lower or higher programme location numbers and the rapid scanning takes place during a continuous operation of one of the two keys, characterized in that a rolling alphanumerical display of the programme location number takes place on a display (16) and in that the tuning of the tuner (10) to a new reception frequency takes place only after termination of the said continuous operation of one of the two keys (5, 6).

2. Apparatus according to Claim 1, characterized in that
- it is a television receiver,
- the said keys (5, 6) are cursor control keys disposed on a remote controller (FB), and
- the rolling display of the programme location number takes place on the picture screen (16) of the television receiver.

3. Apparatus according to Claim 2, characterized in that the programme change operation is signalled alphanumerically on the picture screen (16) in addition to the rolling display of the programme location number.

4. Apparatus according to Claim 1, characterized in that
- it is a television receiver,
- the said keys (5, 6) are cursor control keys disposed on a remote controller (FB), and
- the rolling display of the programme location number takes place on a display disposed on the front operating panel of the television receiver.

5. Television receiver having a tuner which is tunable to the reception frequencies assigned to the individual programme location numbers, an operating unit for choosing the programme location numbers by means of two keys, one of which is provided for choosing programme locations having lower programme location number and the other for choosing programme locations having higher programme location number, the operating unit being capable of operation in an operating mode in which a rapid scanning takes place in the direction of lower or higher programme location numbers and the rapid scanning takes place during a continuous operation of one of the two keys, characterized in that, during the rapid scanning in the direction of lower or higher programme location numbers, abbreviated transmitter designations assigned to the programme location numbers are displayed in tabular form on the picture screen (16) of the television set, the rapid scanning being signalled visually in the table, and in that the tuning of the tuner (10) to a new reception frequency takes place only after termination of the said continuous operation of one of the two keys (5, 6).

6. Apparatus according to one or more of the preceding claims, characterized in that, during the said continuous operation of one of the two keys (5, 6), the tuning of the tuner (10) to the reception frequency tuned to before the start of the continuous operation is maintained.

7. Apparatus according to one or more of the preceding claims, characterized in that, during the said continuous operation of one of the two keys (5, 6), the picture screen (16) is blanked.

8. Apparatus according to one or more of Claims 1-6, characterized in that, during the said continuous operation of one of the two keys (5, 6) a picture from a picture memory is displayed on the picture screen (16).

9. Apparatus according to one or more of the preceding claims, characterized in that the two keys are the ends of a rocker switch.

## Revendications

1. Appareil de l'électronique du spectacle comportant un syntoniseur, qui peut être accordé sur des fréquences de réception associées aux numéros individuels d'emplacements de programmes, et une unité de commande pcur sélectionner les numéros d'emplacements de programmes à l'aide de deux touches, dont l'une est prévue pour la sélection d'emplacements de programmes ayant des numéros plus petits et dont l'autre est prévue pour sélectionner les emplacements de programmes ayant des numéros plus grands, l'unité de commande pouvant fonctionner dans un type de fonctionnement dans lequel un balayage rapide des numéros d'emplacements de programmes est exécuté dans le sens des numéros décroissants ou des numéros croissants, et le balayage rapide s'effectue pendant un actionnement continu de l'une des deux touches,
caractérisé en ce qu'un affichage alphanumérique continu d'éléments ou d'emplacements de programmes est exécuté sur un dispositif d'affichage (16) et que l'accord du syntoniseur (10) sur une nouvelle fréquence de réception intervient seulement après la fin de l'actionnement continu indiqué de l'une des deux touches (5,6).

2. Appareil selon la revendication 1, caractérisé en ce
- qu'il s'agit d'un récepteur de télévision,
- que lesdites touches (5,6) sont des touches de commande à curseur disposées sur un générateur de télécommande (FB), et
- que l'affichage continu des numéros d'emplacements de programmes s'effectue sur l'écran (16) de l'appareil de télévision.

3. Appareil selon la revendication 2, caractérisé en ce que l'opération de changement de programme est signalée de façon supplémentaire dans le mode alphanumérique sur l'écran (16) lors de l'affichage continu des numéros d'emplacements de programmes.

4. Appareil selon la revendication 1,
- qu'il s'agit d'un récepteur de télévision,
- que lesdites touches (5,6) sont des touches de commande à curseur disposées sur un générateur de télécommande (FB), et
- que l'affichage continu des numéros d'emplacements de programmes s'effectue sur un dispositif d'affichage disposé sur la partie avant de commande du récepteur de télévision.

5. Récepteur de télévision comportant un syntoniseur, qui peut être accordé sur des fréquences de réception associées aux numéros individuels d'emplacements de programmes, et une unité de commande pour sélectionner les numéros d'emplacements de programmes à l'aide de deux touches, dont l'une est prévue pour la sélection d'emplacements de programmes ayant des numéros plus petits et dont l'autre est prévue pour sélectionner les emplacements de programmes ayant des numéros plus grands, l'unité de commande pouvant fonctionner dans un type de fonctionnement dans lequel un balayage rapide des numéros d'emplacements de programmes est exécuté dans le sens des numéros décroissants ou des numéros croissants, et le balayage rapide s'effectue pendant un actionnement continu de l'une des deux touches,
caractérisé en ce que pendant le parcours rapide dans le sens des numéros décroissants ou des numéros croissants sur l'écran (16) du récepteur de télévision, des désignations abrégées d'émetteurs, qui sont associées aux numéros d'emplacements de programmes, sont représentées sous la forme d'un tableau, le balayage rapide du tableau étant signalé optiquement, et que l'accord du syntoniseur (10) de la nouvelle fréquence de réception s'effectue uniquement à la fin dudit actionnement continu de l'une des deux touches (5, 6).

6. Appareil selon l'une des revendications précédentes, caractérisé en ce que pendant ledit actionnement continu de l'une des deux touches (5,6), l'accord du syntoniseur (10) sur la fréquence de réception réglée avant le début de l'actionnement permanent, est conservé.

7. Appareil selon l'une des revendications précédentes, caractérisé en ce que ledit actionnement continu de l'une des deux touches (5,6), l'écran (16) est commandé de manière à rester éteint.

8. Appareil selon l'une des revendications 1-6, caractérisé en ce que pendant ledit actionnement continu de l'une des deux touches (5,6), une image tirée d'une mémoire d'images est représentée sur l'écran (16).

9. Appareil selon l'une des revendications précédentes, caractérisé en ce que les deux touches sont les extrémités d'un interrupteur à bascule.
